(19) Europäisches Patentamt
European Patent Office
Office européen des brevets

(11) **EP 1 633 001 A1**

(12) **EUROPEAN PATENT APPLICATION**
published in accordance with Art. 158(3) EPC

(43) Date of publication:
**08.03.2006 Bulletin 2006/10**

(51) Int Cl.:
*H01L 27/092* (1990.01)    *H03D 7/14* (1968.09)
*H04B 1/30* (1968.09)    *H01L 29/78* (1974.07)
*H01L 21/336* (1990.01)

(21) Application number: **04745810.4**

(22) Date of filing: **11.06.2004**

(86) International application number:
**PCT/JP2004/008216**

(87) International publication number:
**WO 2004/112141 (23.12.2004 Gazette 2004/52)**

(84) Designated Contracting States:
**DE**

(30) Priority: **12.06.2003 JP 2003168530**
**26.06.2003 JP 2003183609**

(71) Applicants:
• **KABUSHIKI KAISHA TOYOTA JIDOSHOKKI**
**Kariya-shi,**
**Aichi 448-8671 (JP)**
• **Niigata Seimitsu Co., Ltd.**
**Jyoetsu-shi,**
**Niigata 943-0834 (JP)**
• **OHMI, Tadahiro**
**Sendai-shi,**
**Miyagi 980-0813 (JP)**

(72) Inventors:
• **OHMI, Tadahiro**
**Sendai-shi,**
**Miyagi 9800813 (JP)**

• **NISHIMUTA, Takefumi**
**Kariya-shi,**
**Aichi 4488671 (JP)**
• **MIYAGI, Hiroshi**
**c/o NIIGATA SEIMITSU CO., LTD.**
**Joetsu-shi,**
**Niigata 9430831 (JP)**
• **SUGAWA, Shigetoshi**
**Sendai-shi,**
**Miyagi 9800861 (JP)**
• **TERAMOTO, Akinobu**
**Sendai-shi,**
**Miyagi 9830037 (JP)**

(74) Representative: **TBK-Patent**
**Bavariaring 4-6**
**80336 München (DE)**

(54) **FREQUENCY CONVERTING CIRCUIT OF DIRECT CONVERSION RECEPTION, SEMICONDUCTOR INTEGRATED CIRCUIT THEREOF, AND DIRECT CONVERSION RECEIVER**

(57) A rectangular parallelepiped p-channel MOS transistor 21 having a height of $H_B$ and a width of $W_B$ is formed on a silicon substrate, and a gate oxide film is formed on a part of the top surface and the side surface of the p-channel MOS transistor 21. A source and a drain are formed on both sides of a gate electrode 26 to form a MOS transistor. The MOS transistor configures a direct conversion receiving circuit. Thus, an error between an I signal and a Q signal in a direct conversion receiving frequency conversion circuit can be reduced.

F I G. 4

EP 1 633 001 A1

## Description

## Technical Field

The present invention relates to a frequency conversion circuit for direct conversion receiving formed on the substrate of a semiconductor integrated circuit, the semiconductor integrated circuit, and a direct conversion receiver.

## Background Art

Conventionally, in the production process of a MOS transistor, a thermal oxide film is formed on the silicon surface with a high temperature of 800°C, and a MOS transistor is produced using the thermal oxide film as a gate insulating film.

It is needed to form an oxide film in a lower temperature environment to enhance the production efficiency of a semiconductor. To realize the request, for example, the patent document 1 discloses the technology of forming an insulating film in a low temperature plasma atmosphere.

In the wireless communication field of a mobile telephone, etc., a circuit is integrated to realize smaller and lower cost equipment.

As a system of demodulating a radio signal, a super-heterodyne system of converting a received signal to an intermediate frequency, amplifying the frequency, and converting the result to a baseband signal, and a direct conversion system of converting a received signal directly to a baseband signal.

The direct conversion system requires no filter, etc. for removing an image generated when conversion to an intermediate frequency signal is performed. Therefore, a receiver can be configured with a simpler circuit.

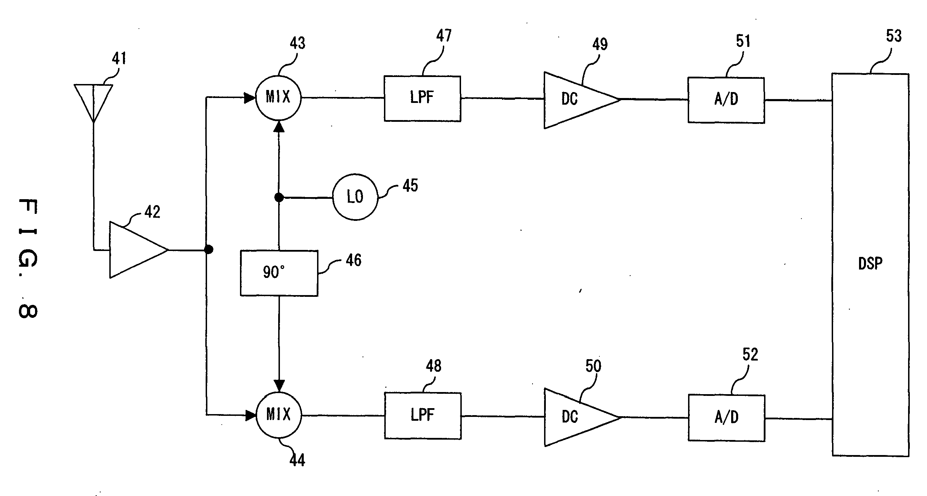

Fig. 8 shows an important portion of the circuit of a direct conversion receiver.

A radio signal received by an antenna 41 is amplified by a low noise amplifier 42 and input to mixer circuits 43 and 44.

A local signal generated by a local oscillation circuit 45 is input to the other input terminal of the mixer circuit 43, and the local signal is shifted 90 degrees by a phase shifter 46, and the shifted local signal is input to the other input terminal of the mixer circuit 44.

In the mixer circuits 43 and 44, the received signal and the local signals are mixed, and converted to a baseband signal having a 90 degree phase difference. Then, the low pass filters 47 and 48 attenuate a signal exceeding a predetermined frequency, and output the resultant signal to the DC amplifiers 49 and 50.

The DC amplifier 49 and 50 amplifies a baseband signal to a signal level depending on the resolution of the A/D converters 51 and 52.

The A/D converters 51 and 52 convert an analog baseband signal to a digital signal, and output the resultant signal to the digital signal processor (DSP) 53. The DSP 53 demodulates a signal by performing a digital signal processing on a baseband signal.

In the above-mentioned direct conversion receiving circuit, a DC offset is generated by a mixer, etc., and a DC offset is contained in the I signal and the Q signal of a baseband.

To solve the problem, for example, the patent document 1 includes a variable amplifier, a phase adjuster, and a mixer, sets a phase and amplification level to have the smallest DC offset as a predetermined receiving frequency, stores the set value, and removes the DC offset of the I signal and the Q signal by setting to the stored set value the phase and the amplification level of the phase adjuster and the variable amplifier when a receiving frequency is selected.

The patent document 2 describes forming a three-dimensional gate on the silicon.

Patent Document 1: Japanese Published Patent Application No. 2001-119316 (Fig. 1, paragraph 0016 0017, etc.)

Patent Document 2: Japanese Published Patent Application No. 2002-110963 (Fig. 1)

However, the method according to the patent document 1 has the problem that a phase adjustment circuit, a variable amplification circuit, etc. are required, thereby complicating a receiving circuit.

In addition, the variance in characteristic of the MOS transistor of a frequency conversion circuit generates a phase error, an amplification error, etc., and the I signal and the Q signal contain a phase error, an amplification error, etc.

## Disclosure of Invention

The present invention aims at reducing the error of the I signal and the Q signal of a frequency conversion circuit for direct conversion receiving. The present invention further aims at reducing the 1/f noise and the DC offset of a direct conversion receiving circuit. The present invention further aims at reducing the distortion of a signal of the direct conversion receiving circuit.

In the frequency conversion circuit for direct conversion receiving according to the present invention, a circuit for performing orthogonal transform on a received signal and converting the signal to an I signal and a Q signal is formed on the substrate of a semiconductor integrated circuit, and includes a differential amplification circuit including an MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion.

According to the invention, by reducing the variance of the features of the MIS field-effect transistor, the phase error, the amplification error, etc. can be reduced, and the error of the I signal and the Q signal can be reduced. Thus, it is not necessary to provide a phase adjustment circuit, etc. in the frequency conversion circuit.

Additionally, by generating a three-dimensional gate, and forming the gate insulating film in a low plasma atmosphere, the effect of a channel length modulation effect can be reduced, and the distortion of a signal in the frequency conversion circuit can be decreased.

Furthermore, by reducing the variance of the features (for example, a threshold voltage, etc.) of the MIS field-effect transistor, for example, the DC offset and 1/f noise of a plurality of mixer circuits forming the frequency conversion circuit can be reduced to approximately the same level.

In addition, the current drive capability of the MIS field-effect transistor can be improved, and the device area of the MIS field-effect transistor on the primary surface of the silicon substrate can be reduced.

In the above-mentioned invention, after removing the terminated hydrogen on the silicon surface in the plasma atmosphere of an inert gas, the gate insulating film is formed, and the content of the hydrogen in the gate insulating film is set to $10^{11}/cm^2$ or lower in the surface density conversion.

An inert gas is formed by, for example, argon, krypton, xenon, etc.

With the above-mentioned configuration, the damage on the silicon surface can be reduced, the evenness level can be enhanced, and the variance of the features (for example, a threshold voltage, etc.) of an MIS field-effect transistor can be decreased. Thus, the DC offset and the 1/f noise of the frequency conversion circuit can be reduced. The reduction of the 1/f noise is specifically effective in the frequency conversion circuit in the direct conversion system for directly converting a received signal to an audio signal.

In the above-mentioned invention, the projecting portion has a top silicon surface (100) and the side silicon surface (110), with the source and the drain formed in the left and right areas of the projecting portion and the projecting portion of the silicon substrate enclosing the gate.

With the above-mentioned configuration, a channel can be formed on the surfaces (100) and (110) of the silicon substrate. Therefore, the current drive capability of the field-effect transistor can be improved.

In the above-mentioned invention, the frequency conversion circuit includes a p-channel MIS field-effect transistor and an n-channel MIS field-effect transistor, and the gate width of the top surface and the side surface of the projecting portion of the p-channel MIS field-effect transistor is set such that the current drive capability of the p-channel MIS field-effect transistor can be substantially equal to the current drive capability of the n-channel MIS field-effect transistor.

With the above-mentioned configuration, the parasitic capacity of the p-channel MIS field-effect transistor can be substantially equal to the parasitic capacity of the n-channel MIS field-effect transistor. Thus, the feature of the amplification circuit can be improved, and the noise can be reduced during switching.

In the semiconductor integrated circuit for direct conversion receiving according to the present invention, a frequency conversion circuit for performing orthogonal transform on a received signal and converting the signal to an I signal and a Q signal is formed on the substrate of a semiconductor integrated circuit, and includes a circuit including: a p-channel MIS field-effect transistor and an n-channel MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a frequency conversion circuit having a differential amplification circuit including the p-channel MIS field-effect transistor or the n-channel MIS field-effect transistor.

According to the invention, the phase error, the amplification error, etc. generated in the frequency conversion circuit can be reduced, and the error of the I signal and the Q signal can be decreased by reducing the variance of the feature of an MIS field-effect transistor.

Furthermore, the influence of the channel length modulation effect can be suppressed and the distortion of a signal in the frequency conversion circuit can be decreased by forming a gate in a three-dimensional structure and a gate insulating film in the low temperature plasma atmosphere.

In addition, by forming the gate insulating film on a different crystal surface in the three-dimensional structure, the current drive capability of the MIS field-effect transistor can be improved and the device area of the MIS field-effect transistor on the primary surface of the silicon substrate can be smaller.

Also, using the above-mentioned p-channel MIS field-effect transistor and the n-channel MIS field-effect transistor for the circuit other than the frequency conversion circuit, the distortion of the signal in the circuit can be reduced. Furthermore, the 1/f noise and the DC offset can also be reduced. The reduction of the 1/f noise is specifically effective for the frequency conversion circuit in the direct conversion system of directly converting a received signal to an audio signal.

In the above-mentioned invention, the widths of the top surface and the side surface of the p-channel MIS field-effect transistor and the n-channel MIS field-effect transistor are set such that the current drive capability of the p-channel MIS field-effect transistor can be substantially equal to the current drive capability of the n-channel MIS field-effect transistor.

In the above-mentioned invention, the frequency conversion circuit is configured by a CMOS circuit including the p-channel MIS field-effect transistor and the n-channel MIS field-effect transistor.

With the above-mentioned configuration, the current drive capability of the p-channel MIS field-effect transistor can be substantially equal to the current drive capability of the n-channel MIS field-effect transistor. Thus, the noise during switching can be symmetric between the positive and negative fields.

The direct conversion receiver or the semiconductor integrated circuit for the direct conversion receiver according to the present invention includes on the substrate of a semiconductor integrated circuit: a frequency conversion circuit having a differential amplification circuit formed by an MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a DC amplifier having a differential amplification circuit formed by the MIS field-effect transistor.

Another direct conversion receiver or a semiconductor integrated circuit for the receiver according to the present invention includes on the substrate of a semiconductor integrated circuit: a frequency conversion circuit having a differential amplification circuit formed by an MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a low noise amplifier formed by the MIS field-effect transistor.

Another direct conversion receiver or a semiconductor integrated circuit for the receiver according to the present invention includes on the substrate of a semiconductor integrated circuit: a frequency conversion circuit having a differential amplification circuit formed by an MIS field-effect transistor in which a projecting portion is formed by a silicon substrate having a first crystal surface as a primary surface under a second crystal surface as a side surface, terminated hydrogen on the silicon surface is removed in the plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; a DC amplifier having the differential amplification circuit formed by the MIS field-effect transistor; and a low noise amplifier formed by the MIS field-effect transistor.

According to the above-mentioned invention, the 1/f noise and the DC offset in a direct conversion receiving circuit can be reduced. Furthermore, the effect of the channel length modulation effect can be decreased, and the distortion of the signal in the circuit can be reduced.

**Brief Description of the Drawings**

Fig. 1 is a sectional view of the plasma device using a radial line slot antenna;
Fig. 2 shows the comparison of the interface level density;
Fig. 3 shows the structure of a silicon substrate produced in the semiconductor production process according to an embodiment of the present invention;
Fig. 4 shows the structure of the MOS transistor produced in the semiconductor production process according to an embodiment of the present invention;
Fig. 5 shows the circuit of a mixer;

Fig. 6 shows the circuit of a DC amplifier;
Fig. 7 shows the circuit of a low noise amplifier; and
Fig. 8 shows the receiving circuit in the conventional direct conversion system.

## Best Mode for Carrying Out the Invention

An embodiment of the present invention is explained below by referring to the attached drawings. Described below first is a semiconductor production process of forming a gate insulating film (for example, an oxide film) on the silicon substrate at a low temperature using an inert gas in a plasma state, and producing a MIS (metal insulator semiconductor) field-effect transistor. The method for forming a gate insulating film is disclosed in Japanese Published Patent Application No. 2002-261091.

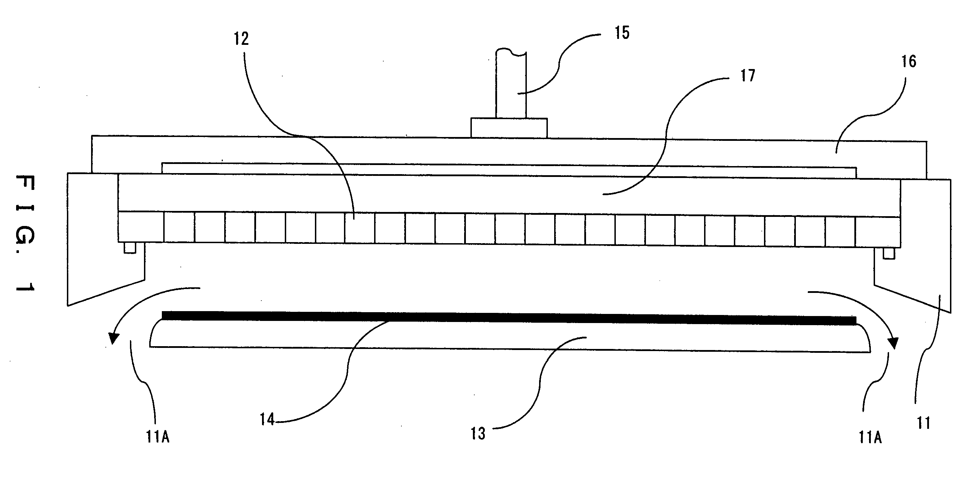

Fig. 1 is a sectional view of the plasma device using a radial line slot antenna to be used in the semiconductor production process.

A vacuum is produced in a vacuum container (processing chamber) 11, an argon gas (Ar) if introduced from a shower plate 12, the Ar gas is exhausted from an outlet 11A, and the gas is switched to a krypton gas. The pressure in the processing chamber 11 is set to 133 Pa ( 1 Torr).

Then, a silicon substrate 14 is placed on a sample table 13 having a heating mechanism, and the temperature of a sample is set to approximately 400°C. If the temperature of the silicon substrate 14 is between 200°C and 550°C, the following result is almost the same.

The silicon substrate 14 is cleansed with noble fluoride acid in the pretreatment process performed immediately before, and the unused coupling of silicon on the surface is terminated with hydrogen as a result.

Next, a microwave at the frequency of 2.45 GHz is supplied from a coaxial waveguide 15 to a radial line slot antenna 16, and the microwave is introduced from the radial line slot antenna 16 to the processing chamber 11 through a dielectric plate 17 provided in a portion of the wall. The introduced microwave pumps the Kr gas introduced from the shower plate 12 to the processing chamber 11. As a result, a high density Kr plasma is formed immediately below the shower plate 12. If the frequency of the provided microwave is about 900 MHz or more and about 10 GHz or less, the following results are almost the same.

With the configuration shown in Fig. 1, the interval between the shower plate 12 and the silicon substrate 14 is set to about 6 cm. The film can be formed at a higher speed with the smaller interval.

The plasma can be pumped by introducing the microwave to the processing chamber using another method without limiting the plasma device to a device using a radial line slot antenna.

By exposing the silicon substrate 14 to the plasma pumped by the Kr gas, the surface of the silicon substrate 14 receives the irradiation of Kr ion of low energy, and the surface terminated hydrogen is removed.

Then, $Kr/O_2$ mixed gas having the partial pressure ratio of 97/3 is introduced from the shower plate 12. At this time, the pressure in the processing chamber is to be kept at approximately 133 Pa (1 Torr). In the high density pumped plasma as a mixture of a Kr gas and an $O_2$ gas, the Kr* and the $O_2$ molecule in the intermediate pumped state conflict with each other, and a large amount of atomic oxygen O* can be efficiently generated.

In the present embodiment, the surface of the silicon substrate 14 is oxidized by the atomic oxygen O*. In the conventional thermal oxidation method, oxidation is performed by an $O_2$ molecule and an $H_2O$ molecule, and a very high process temperature over 800 °C is required. In the oxidization process using the atomic oxygen performed in the present embodiment, the oxidization process at a very low temperature of approximately 400°C can be performed. To extend the conflict opportunity between Kr* and $O_2$, it is desired that a higher pressure is kept in the processing chamber. However, if the pressure is too high, the generated O* conflict with each other and is returned to an $O_2$ molecule. Therefore, the optimum gas pressure is to be maintained.

When a desired thickness of film of a silicon oxide film (silicon compound layer) is formed, the introduction of the microwave power is stopped to terminate the plasma pumping, and the $Kr/O_2$ mixture gas is replaced with an Ar gas, thereby terminating the oxidization process. The Ar gas is used before and after the present process to use a gas less expensive than the Kr as a purge gas. The Kr gas used in this process is collected for recycle.

After forming the above-mentioned oxide film, an electrode forming process, a protective film forming process, a hydrogen sintering process, etc. are performed to generate a semiconductor integrated circuit including a transistor and a capacitor.

As a result of measuring the hydrogen content in the silicon oxide film formed in the above-mentioned procedure, it is lower than $10^{12}$ /cm$^2$ after a surface density transform on the silicon oxide film of the film thickness of 3nm. Especially, on the oxide film having a small leak current, the hydrogen content in the silicon oxide film is $10^{11}$/cm$^2$ or less in the surface density conversion. On the other hand, the oxide film not exposed to the Kr plasma before forming the oxide film contains hydrogen of $10^{12}$/cm$^2$ or more in the surface density conversion.

When the oxidization process is performed with the $Kr/O_2$ gas introduced after removing the terminated hydrogen by irradiation with Kr plasma as described above, the leak current at the same voltage as the silicon oxide film formed by the conventional microwave plasma oxidization is reduced by two or three digits of the leak current, thereby obtaining a very excellent low leak feature. The improvement of the leak current feature has been confirmed in the production of an integrated circuit using the silicon oxide film having the film thickness up to about 1.7 nm.

When the surface direction dependency of the silicon/silicon oxide film interface level density is measured relating to the silicon oxide film obtained in the above-mentioned semiconductor production process, a very low interface level density of about $1 \times 10^{10}$ $eV^{-1}$ $cm^{-2}$ is obtained any of the surface direction of the silicon surface.

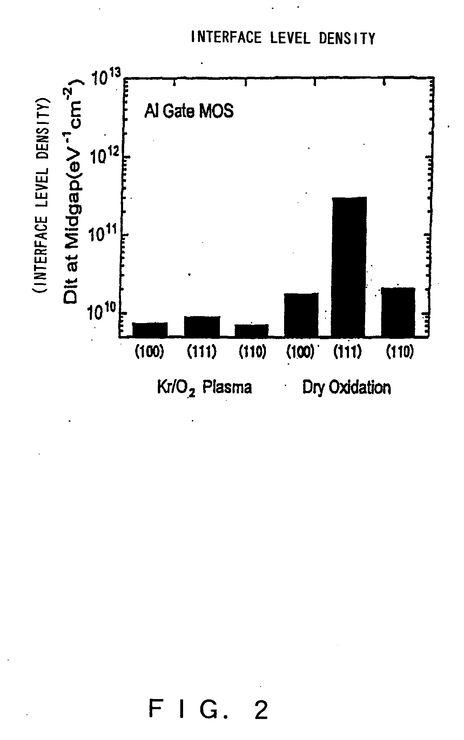

Fig. 2 shows the $Kr/O_2$ film formed by the above-mentioned semiconductor production process on each of the surfaces (100), (110), and (111) of a silicon substrate, and a result of measuring the interface level density of the conventional thermal oxide film.

As shown in Fig. 2, when the $Kr/O_2$ film is generated, the interface level density of the semiconductor on any of the surfaces (100), (110), and (111) is $10^{10}$ $eV^{-1}$ $cm^{-2}$ or lower. On the other hand, the interface level density of the thermal oxide film on the surface (100) formed in an atmosphere higher than the conventional 800°C is 1.1 times greater or more, and in the above-mentioned semiconductor production process, a high quality insulating film of a low interface level density can be formed.

By lowering the interface level density, the probability of recombining a carrier can be reduced, thereby lowering the 1/f noise.

Relating to the electric features such as the pressure-resistant feature, the hot carrier resistance, the electric charge QBD (charge-to-breakdown) up to the destruction of the silicon oxide film when a stress current flows, etc. and the reliability feature, the oxide film formed in the semiconductor production process indicates good features equivalent to or higher than the conventional thermal oxide film.

As described above, by performing the high grade silicon oxidization process on silicon in all surface directions at a low temperature of 400°C by performing the silicon oxidization process using $Kr/O_2$ high density plasma after removing the surface terminated hydrogen. It is considered that the above-mentioned effect can be obtained by a decreasing hydrogen content in the oxide film by removing the terminated hydrogen, and by containing an inert gas (Kr for example) in the oxide film. By a small amount of hydrogen in the oxide film, there is no weak coupling of elements in the silicon oxide film, and by containing Kr, the stress in the film or on the $Si/SiO_2$ interface is moderated. As a result, the electric characteristic of the silicon oxide film can be largely improved.

In the above-mentioned semiconductor production process, it is considered that the hydrogen density of $10^{12}/cm^2$ or less in the surface density conversion, or $10^{11}/cm^2$ or less as a desired condition, and Kr density of $5 \times 10^{11}$ $/cm^2$ or less contribute to the improvement of the electric characteristics and reliability characteristics of the silicon oxide film.

In the above-mentioned semiconductor process, a silicon nitride film and a silicon oxide and nitride film can be formed using a mixture of an inert gas and a $NH_3$ gas and a mixture of an inert gas, $O_2$, and $NH_3$.

The effect obtained by forming a nitride film is mainly based on the presence of hydrogen in plasma even after removing the surface terminated hydrogen. By the hydrogen in plasma, the dangling bond in the silicon nitride film and on the interface forms a coupling of Si-H and N-H and is terminated, and, as a result, the electronic trap in the silicon nitride film and on the interface disappear.

It is considered that the effect obtained by forming an oxide and nitride film is caused not only by the decrease in the hydrogen content in the oxide and nitride film by removing the terminated hydrogen, but also by some percents of nitrogen contained in the oxide and nitride film. The Kr content in the oxide and nitride film is 1/10 or less of the content in the oxide film, and the content of nitrogen is larger than that of Kr. That is, since the hydrogen content is small in the oxide and nitride film, the rate of weak couplings in the silicon nitride film decreases, and the contained nitrogen moderates the stress in the film, $Si/SiO_2$, or on the interface. As a result, it is considered that the charge in the film and the interface level density decrease, and the electric characteristic of the oxide and nitride film has been largely improved.

The desired result obtained by forming an oxide film or an oxide and nitride film is not only caused by removing the terminated hydrogen, but also caused by containing Ar or Kr in the nitride film or the oxide and nitride film. That is, in the nitride film obtained in the above-mentioned semiconductor production process, the stress in the nitride film of on the silicon/nitride film interface is moderated by Ar or Kr contained in the nitride film. As a result, the fixed charge in the silicon nitride film and the interface level density are reduced, and the electric characteristic, and especially the 1/f noise is reduced, thereby largely improving the reliability.

The inert gas used in the above-mentioned semiconductor production process is not limited to an Ar gas, a Kr gas, but a xenon Xe gas can also be used.

Furthermore, after forming a silicon oxide film and a silicon nitride film, the pressure in a vacuum container 1 is maintained at 133 Pa (1 Torr), a gas of a mixture of $Kr/NH_3$ at a partial pressure ratio of 98/2 is introduced, and about 0.7 nm silicon nitride film can be formed on the surfaces of a silicon oxide film and a silicon oxide and nitride film.

Thus, a silicon oxide film having a silicon nitride film formed on the surface, or a silicon oxide and nitride film can be obtained. Therefore, an insulating film having a high dielectric constant can be formed.

To realize the above-mentioned semiconductor production process, in addition to the device shown in Fig. 1, another plasma process device capable of forming a low temperature oxide film using plasma can be used. For example, it is possible to use a 2-stage shower plate type plasma process device having the first gas emission structure of emitting an Ar or Kr gas for pumping plasma, and a second gas emission structure which is different from the first gas emission structure and emits an $O_2$, $NH_3$, or $N_2/H_2$ gas.

Described below is the semiconductor production process according to an embodiment of the present invention. The semiconductor process forms a gate insulating film of a MIS field-effect transistor on the surface (100) and the surface (110).

When a p-channel transistor is formed on the surface (111), 1.3 times the current drive capability of the surface (100) is obtained. If it is formed on the surface (110), 1.8 times the current drive capability of the surface (100) is obtained.

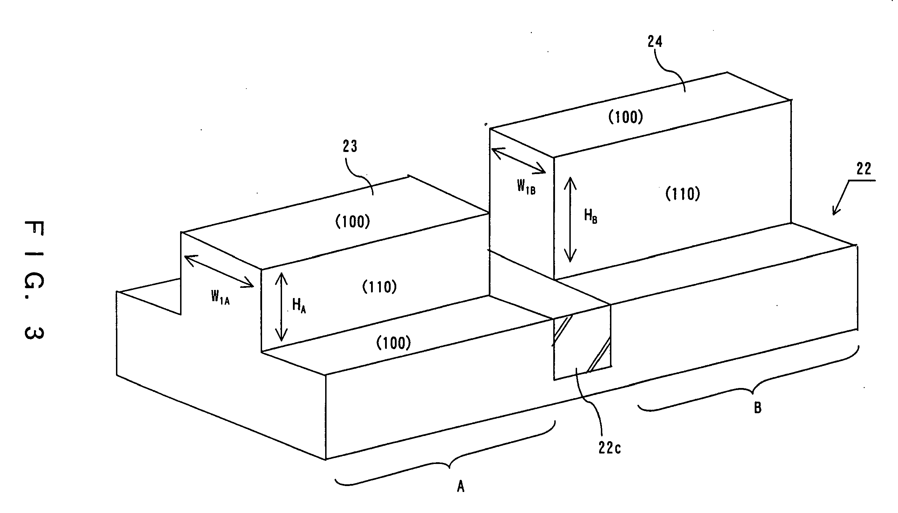

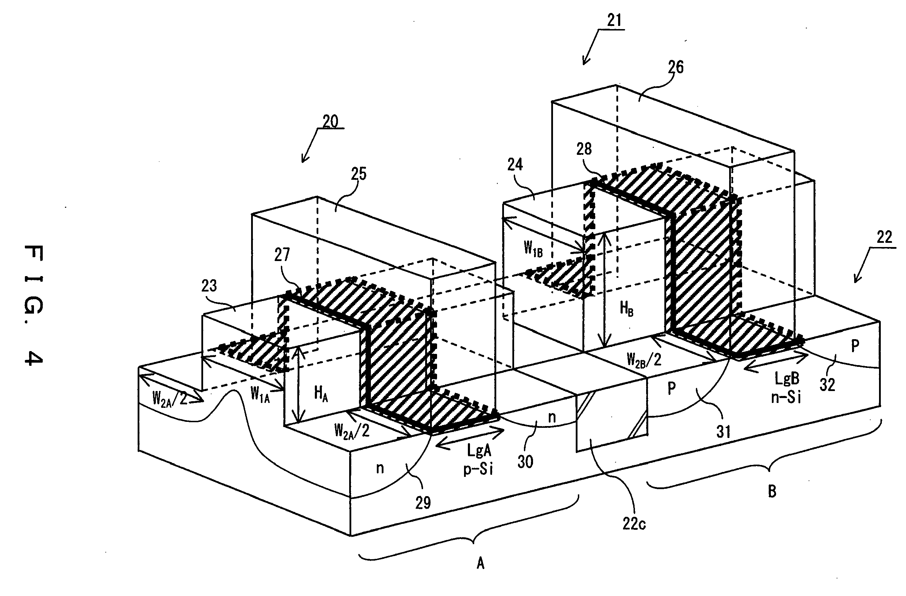

Fig. 3 shows the state of forming projecting portions 23 and 24 having surfaces (100) and (110) on a silicon substrate 22 in the semiconductor production process according to an embodiment of the present invention. Fig. 4 shows the structures of an n-channel MOS transistor 20 and a p-channel MOS transistor 21 produced in the semiconductor production process according to an embodiment of the present invention. Fig. 4 shows a channel formed at the lower portion of the gate oxide film and indicated by diagonal lines.

As shown in Fig. 3, the silicon substrate 22 having the surface (100) as a primary surface is separated by a device separation area 22c into p-type area A and an n-type area B. In the area A, the rectangular parallelepiped projecting portion 23 having a height of $H_A$ and a width of $W_{1A}$ is formed on the reference of the surface (100). Similarly, in the area B, the projecting portion 24 having a height of $H_B$ and a width of $W_{1B}$ is formed.

As shown in Fig. 4, a silicon oxide film is formed in the semiconductor production process on the surface of the silicon substrate 22 and the top surfaces and the side surfaces of the projecting portions 23 and 24.

On the silicon oxide film, polysilicon gate electrodes 25 and 26 are formed, the silicon oxide film is patterned when the polysilicon gate electrodes 25 and 26 are formed, and gate insulating films 27 and 28 are formed below the polysilicon gate electrodes 25 and 26.

In addition, an n-type impure ion is injected into the areas on both sides of the gate electrode 25 of the p-type area A, thereby forming n-type diffusion areas 29 and 30 including the projecting portion 23. The n-type diffusion areas 29 and 30 configure the source and the drain of the n-channel MOS transistor 20. Also in the n-type area B, a p-type impure ion is injected into the areas on both sides of the gate electrode 26, thereby forming p-type diffusion areas 31 and 32 including the projecting portion 24. The p-type diffusion areas 31 and 32 configure the source and drain of the p-channel MOS transistor 21.

When a predetermined voltage is applied to the gate electrodes 25 and 26 of the p-channel MOS transistor 21 and the n-channel MOS transistor 20, a channel indicated by the diagonal lines shown in Fig. 4 is formed below the gate oxide films 27 and 28.

The gate width of the surface (100) of the n-channel MOS transistor 20 is $W_{1A}$ on the top surface (top surface of the projecting portion 23) of the projecting portion 23, and $W_{2A}/2$ on the flat portions of the silicon substrate 22 on the right and left below the projecting portion 23. Therefore, it is a total of $W_{1A} + W_{2A}$. Similarly, the gate width of the surface (110) of the n-channel MOS transistor 20, that is, the gate widths of the left and right side surfaces of the projecting portion 23 are $H_A$. Therefore, it is a total of $2H_A$. The gate width corresponds to the channel width. The gate length of the n-channel MOS transistor 20 is LgA.

Accordingly, the current drive capability of the n-channel MOS transistor 20 is expressed by $\mu_{n1} (W_{1A} + W_{2A}) + \mu_{n2} \cdot 2H_A$. $\mu_{n1}$ indicates the electron mobility on the surface (100), $\mu_{n2}$ indicates the electron mobility on the surface (110).

Similarly, the gate width of the surface (100) of the p-channel MOS transistor 21 is $W_{1B}$ on the top surface of the projecting portion 24, and $W_{2B}/2$ at the flat portions of the silicon substrate 22 on the left and right below the projecting portion 24. Therefore, it is a total of $W_{1B} + W_{2B}$. The gate width of the surface (110) of the p-channel MOS transistor 21, that is, the gate widths on the left and right side surfaces of the projecting portion 24 are $H_B$. As a result, the gate width is a total of $2H_B$. The gate width corresponds to the channel width. The gate length of the p-channel MOS transistor 21 is LgB.

Therefore, the current drive capability of the p-channel MOS transistor 21 can be expressed by $\mu_{p1} (W_{1B} + W_{2B}) + \mu_{p2} \cdot 2H_B$. $\mu_{p1}$ indicates the Hall mobility on the surface (100), and $\mu_{p2}$ indicates the Hall mobility on the surface (110).

Thus, by setting the respective heights $H_A$ and $H_B$ of the projecting portions 23 and 24, the current drive capability of the p-channel MOS transistor 21 and the current drive capability of the n-channel MOS transistor 20 can be balanced. This condition can be expressed by the following equation.

$$\mu_{n1} (W_{1A} + W_{2A}) + \mu_{n2} \cdot 2H_A = \mu_{p1} (W_{1B} + W_{2B}) + \mu_{p2} \cdot 2 \, H_B$$

By setting the $H_A$ and $H_B$ to the values satisfying the equation above, the current drive capability of the p-channel MOS transistor 21 and the current drive capability of the n-channel MOS transistor 20 can be balanced. In this case, it is not necessary that the channel width of the primary surface (for example, the surface (100)) of the p-channel MOS transistor 21 is to be exceedingly larger than the channel width on the surface (100) of the n-channel MOS transistor 20. Therefore, the difference in parasitic capacity by a gate insulating film can be smaller between them. Thus, when a circuit of a CMOS structure is configured using the p-channel MOS transistor 21 and the n-channel MOS transistor 20, the current value imbalance caused when a parasitic capacity by the gate oxide film of them is charged or discharged can be reduced, and the noise level caused when the transistor of the CMOS structure is switched can be lowered.

The height $H_B$ of the p-channel MOS transistor 21 can be set such that, after setting the height $H_A$ of the gate of the n-channel MOS transistor 20 to "0", the current drive capability of the n-channel MOS transistor 21 can be substantially equal to the current drive capability of the n-channel MOS transistor 20.

Since the area of the gate on the primary surface (for example, the surface (100)) of the silicon substrate of the p-channel or the n-channel MOS transistor can be smaller than in the conventional semiconductor production process when the p-channel MOS transistor 21 or the n-channel MOS transistor 20 is individually formed, the area on the primary surface on the silicon substrate of the p-channel MOS transistor and the n-channel MOS transistor can be smaller, thereby enhancing the integration of a semiconductor circuit. Furthermore, since the parasitic capacities of the p-channel and N-channel MOS transistors can be smaller, the switching speed of the MOS transistors can be increased, and the power consumption at the switching can be reduced.

The insulating film formed on the silicon surface is not limited to an oxide film, but a silicon nitride film, a silicon oxide and nitride film, etc. can be formed.

Described below is the case where the frequency conversion circuit for direct conversion receiving is formed on the semiconductor circuit substrate in the above-mentioned semiconductor production process.

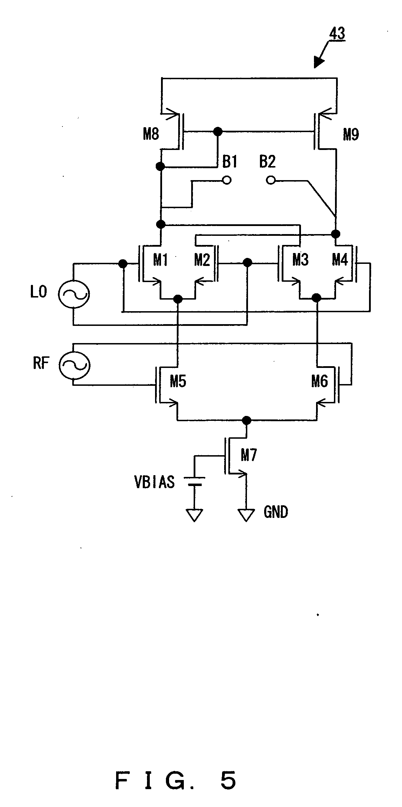

The frequency conversion circuit for direct conversion receiving comprises, for example, the mixer circuit 43, the mixer circuit 44, the local oscillation circuit 45, and the phase shifter 46 shown in Fig. 8. The practical configuration of the mixer circuit 43 is explained below by referring to Fig. 5.

Fig. 5 shows the circuit of a gilbert cell as a double balance mixer. The mixer circuit 43 is configured by p-channel and n-channel MOS transistors.

The mixer circuit 43 has a serial connection of: two sets of differential pairs of n-channel MOS transistors M1 to M4 (differential amplification circuit) where a local oscillation signal (LO signal) is input to a gate; a set of a differential pair of n-channel MOS transistors M5 and M6 (differential amplification circuit) where an RF signal is input to a gate; an n-channel MOS transistor M7 as a constant current source; and p-channel MOS transistors M8 and M9 functioning as a load. A bias voltage VBIAS is supplied to the gate of the MOS transistor M7, and the source is grounded.

The source of the MOS transistors M5 and M6 is connected to the drain of the MOS transistor M7, and an RF signal is differentially input to the gate of the MOS transistors M5 and M6.

The source of the MOS transistors M1 and M2 is connected to the drain of the MOS transistor M5, the source of the MOS transistors M3 and M4 is connected to the drain of the MOS transistor M6, and a local oscillation signal is differentially input to the connection point of the gates of the MOS transistors M1 and M4 and the connection point of the gates of the MOS transistors M2 and M3. Then, a first mixed output terminal B1 connected to the drain of the MOS transistors M1 and M3 is provided, and a second mixed output terminal B2 connected to the drain of the MOS transistors M2 and M4 is provided. The drains of the MOS transistors M1 and M3 and the MOS transistors of M2 and M4 are connected to a power source VDD respectively through the MOS transistors M8 and M9.

If the frequency of the local oscillation signal is equal to the frequency of the RF signal in the mixer circuit 43, a baseband signal is output from the mixed output terminal.

When the gate of the MOS transistor of the mixer circuit 43 is three-dimensionally structured and a gate oxide film is formed in a low temperature plasma atmosphere, the influence of the channel length modulation effect of the differential amplification circuit comprising the MOS transistors M1 and M2, the differential amplification circuit comprising the MOS transistors M2 and M4, and the differential amplification circuit comprising the MOS transistors M5 and M6 can be reduced, thereby decreasing the distortion of the signal when a frequency is converted. In addition, since the influence of the channel length modulation effect of the constant current circuit (comprising the MOS transistors M8 and M9) at the drain or the constant current circuit (comprising the MOS transistor M7) at the source functioning as a load of the differential amplification circuits can be reduced, the fluctuation of the drain current when a drain voltage is changed can be reduced.

The mixer circuit 44 is also configured by the circuit shown in Fig. 5. The difference from Fig. 5 is that a signal obtained by 90 degrees phase-shifting the local oscillation signal generated by the local oscillation circuit 45 is applied to the gates of the MOS transistors M1 to M4.

In the frequency conversion circuit, eliminating the damage of the silicon surface and leveling the surface can reduce the variance of the characteristics (for example, in threshold voltage, etc.) of the MOS transistors. Thus, the phase difference, the amplification error, etc. between the I signal and the Q signal generated in the mixer circuits 43 and 44 can be reduced. Since the level of an error generated in the mixer circuit 43 can be substantially equal to the level of an error generated in the mixer circuit 44, the relative error between the I signal and the Q signal can also be reduced.

In addition, by structuring a gate in a three-dimensional array and forming a gate oxide film in a low temperature plasma atmosphere, the influence of the channel length modulation effect of the amplification circuit and the constant current circuit of MOS transistors can be reduced, and the distortion of a signal in the frequency conversion circuit can be decreased.

Furthermore, the current drive capability of the MOS transistors can be improved, and the device area of a transistor on the primary surface of the silicon substrate can be smaller.

Since the DC offset of the frequency conversion circuit and the 1/f noise can be reduced, it is specifically effective for the frequency conversion circuit in the direct conversion system for directly converting a received signal to an audio signal.

The mixer circuits 43 and 44 can also be configured by, for example, a CMOS circuit comprising an n-channel MOS transistor and a p-channel MOS transistor. In this case, the parasitic capacity of the p-channel MOS transistor can be substantially equal to the parasitic capacity of the n-channel MOS transistor, thereby improving the features of the circuit. Additionally, the noise caused by the imbalance of the current when the p-channel and n-channel MOS transistors are turned on and off can also be reduced.

The channels of the p-channel MOS transistor and the n-channel MOS transistor for use in the DC amplifier, the A/D conversion circuit, the digital circuit, etc. other than the frequency conversion circuit can be produced in the above-mentioned semiconductor process.

With the above-mentioned configuration, the characteristics of the p-channel MOS transistors and the n-channel MOS transistors of other circuits can be prepared. Therefore, the DC offset and the 1/f noise can be reduced. In addition, since the current drive capability of the MOS transistor can be improved, the operation characteristic of a circuit can also be improved.

Furthermore, the widths of the channels of the p-channel MOS transistor and the n-channel MOS transistor of a frequency conversion circuit or other circuits can be designed such that the current drive capability of the p-channel MOS transistor can be substantially equal to the current drive capability of the n-channel MOS transistor as formed on the different crystal surfaces (for example, the surfaces (100) and (110)) of silicon.

With the above-mentioned configuration, the parasitic capacity, etc. of the p-channel MOS transistor can be substantially equal to the parasitic capacity, etc. of the n-channel MOS transistor. Therefore, the switching characteristic can be improved and the noise generated by the current flowing when the MOS transistors are turned ON and OFF can be reduced.

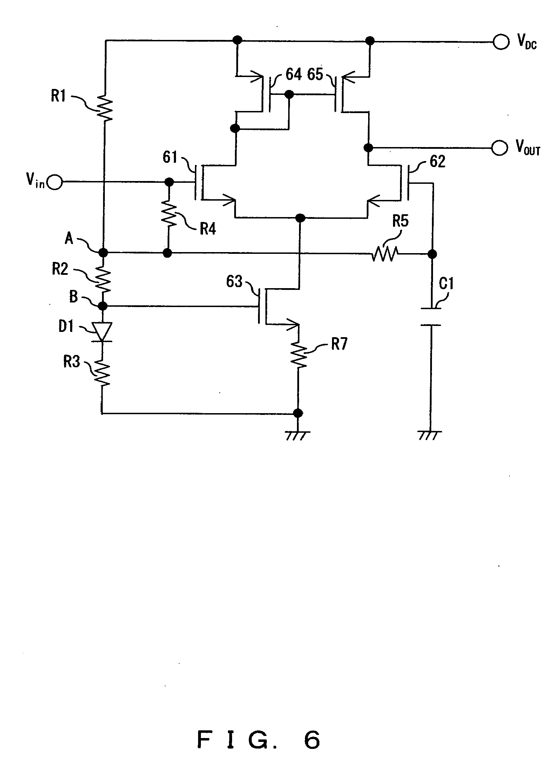

Fig. 6 shows an example of the DC amplifiers 49 and 50 of the direct conversion receiving circuit. The DC amplifier is also produced in the above-mentioned semiconductor production process.

N-channel MOS transistors 61 and 62 configure a differential amplification circuit, a signal Vin output from the low pass filter 47 or 48 is input to the gate of the MOS transistor 61, and a signal -Vin is input to the gate of the MOS transistor 62.

An n-channel MOS transistor 63 and an MOS transistor 64 form a current mirror circuit, and the drain of the MOS transistor 63 is commonly connected to the source of the MOS transistors 61 and 62. The drain of the MOS transistor 64 is connected to the power source voltage VDD through a constant current source 65, and the gate of the MOS transistors 63 and 64 is connected to the drain of the MOS transistor 64.

The MOS transistors 63 and 64 form a constant current circuit, and the constant current source 65 is connected to the drain of the MOS transistor 64. Therefore, a constant current proportional to the current supplied from the constant current source 65 flows through the MOS transistor 63.

P-channel MOS transistors 66 and 67 configure a current mirror circuit, the sources are connected to a power source voltage VDD, and the drains are connected to the drains of the MOS transistors 61 and 62. The gate of the MOS transistor 67 is connected to the drain of the MOS transistor 66. The MOS transistors 66 and 67 function as a load of the MOS transistors 61 and 62.

The DC amplifier comprising the differential amplification circuit differentially amplifies the input signals Vin and -Vin using the MOS transistors 61 and 62, and the amplified signal is output as Vo.

By three-dimensionally structuring the gate of the MOS transistor of the DC amplifier and forming a gate oxide film in a low temperature plasma atmosphere, the influence of the channel length modulation effect of the differential amplification circuit comprising the MOS transistors 61 and 62 can be reduced, and the distortion of the signal in the differential amplification circuit can be decreased. Since the influence of the channel length modulation effect of the constant current circuit (comprising the MOS transistors 66 and 67) at the drain and the constant current circuit (comprising the MOS transistors 63 and 64) at the source functioning as a load of the differential amplification circuit can be reduced, the fluctuation of the drain current in the circuits can be reduced.

As described above, by decreasing the damage on the silicon surface and leveling the surface, the variance of the characteristic of a MOS transistor (for example, a threshold voltage, etc.) can be reduced, thereby decreasing the DC offset of the entire circuit. Thus, a circuit, a capacitor, etc. for removing the DC offset are not required, and the signal gain of the DC amplifier can be increased. By increasing the signal gain of the DC amplifier, for example, a low resolution A/D converter can be used as an A/D converter at a later stage of the DC amplifier of the receiving circuit in the direct conversion system.

Furthermore, by removing the terminated hydrogen on the silicon surface in a plasma atmosphere such as argon, etc. then forming a thin and flat silicon insulating film in a plasma atmosphere including argon, krypton, or xenon including oxygen and a gaseous molecule such as oxygen, nitrogen, etc. and at a temperature of 550°C or less, the interface level density of the silicon surface can be lowered. Thus, the probability of recombination of a carrier can be reduced and the 1/f noise can be decreased. By decreasing the 1/f noise, the S/N ratio of the signal downconverted by the mixer circuits 43 and 44 can be improved. As a result, the gain of the DC amplifier can be increased.

Additionally, since the current drive capability of the MOS transistor can be improved and the device area can be smaller, the integration can be enhanced, and the operation speed can be increased. Furthermore, since the operation characteristic of the field-effect transistor of a DC amplifier is prepared, and the parasitic capacity can be reduced, the frequency characteristic of the differential amplification circuit can be improved, and a DC offset can be reduced, thereby obtaining a large signal gain. Thus, since the DC offset and the 1/f noise can be reduced, it is specifically effective for a DC amplifier in the direct conversion system where a received signal is directly converted to an audio signal.

A DC amplifier can also be configured by a CMOS circuit comprising an n-channel MOS transistor and a p-channel MOS transistor. In this case, the parasitic capacity of the p-channel MOS transistor can be substantially equal to the parasitic capacity of the n-channel MOS transistor, and the parasitic capacity can be smaller, thereby increasing the operation speed, etc. of a circuit. Additionally, the noise by the imbalance of a current when a p-channel MOS transistor and an n-channel MOS transistor are turned ON or OFF can be decreased.

The p-channel MOS transistor and the n-channel MOS transistor used in the frequency conversion circuit, the A/D conversion circuit, the digital circuit, etc. other than the DC amplifier can be produced in the above-mentioned semiconductor process.

With the above-mentioned configuration, since the characteristics of the p-channel MOS transistor and the n-channel MOS transistor of other circuits can be prepared, a DC offset and 1/f noise can be reduced. Additionally, the operation characteristics of a circuit can be improved.

Furthermore, the channels of the p-channel MOS transistors and the n-channel MOS transistors of a DC amplifier or other circuits are formed on different crystal surfaces ( for example, the surface (100) and (110) ) of silicon, and the channel width can be designed such that the current drive capability of a p-channel MOS transistor can be substantially equal to the current drive capability of a n-channel MOS transistor.

With the configuration, the parasitic capacity of the p-channel MOS transistor can be substantially equal to the parasitic capacity of the n-channel MOS transistor. Accordingly, the switching characteristic can be improved, and the noise generated by a current when the MOS transistors are turned ON or OFF can be reduced.

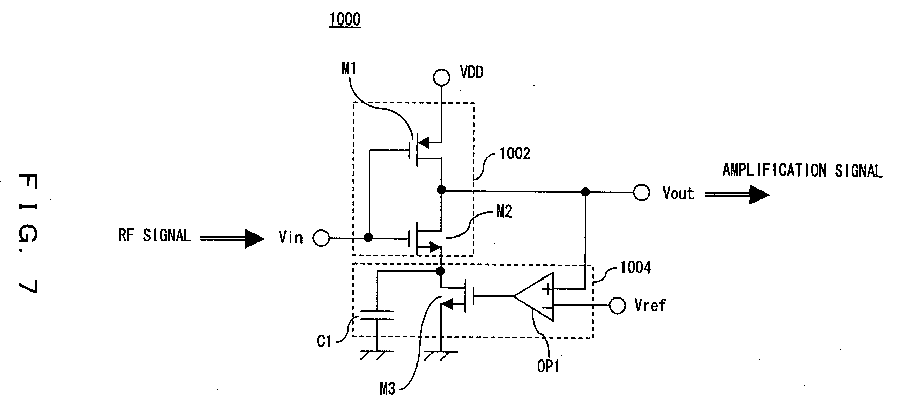

Fig. 7 shows an example of the low noise amplifier 42 of a direct conversion receiving circuit. The low noise amplifier 42 is also produced in the above-mentioned semiconductor production process.

As shown in Fig. 7, a circuit 1000 of the low noise amplifier comprises C MOS transistor 1002 having a combination of the p-channel MOS transistor M1 and the n-channel MOS transistor M2, and an operation point determination circuit 1004 having a combination of the capacitor C1, the n-channel MOS transistor M3, and the operation amplifier OP1.

First, in the C MOS transistor 1002, a common input voltage (for example, an input voltage changing based on the carrier wave received by an antenna, etc.) is applied to the gate of the p-channel MOS transistor M1 and the gate of the n-channel MOS transistor M2. Then, the p-channel MOS transistor M1 and the n-channel MOS transistor M2 are allowed to function as a signal amplifier. Furthermore, according to the present circuit, a voltage source VDD is applied to the drain of the p-channel MOS transistor M1 to obtain a high voltage gain. Then, the amplification voltage of the input voltage is output to the source of the p-channel MIS field-effect transistor M1 and the drain of the n-channel MOS transistor M2.

On the other hand, since the bias current and the drain voltage of the p-channel MOS transistor M1 are subject to the influence of the power source voltage VDD, the operation point determination circuit 1004 is inserted between the source of the p-channel MOS transistor M1 and the n-channel MOS transistor M2, the amplification voltage is controlled based on the reference voltage (Vref) such that the $g_m$ can be suppressed to reduce the thermal noise and 1/f noise, thereby determining the operation point. C1 is inserted to reduce the thermal noise.

In the C MOS transistor 1002 indicated in this circuit, the 1/f noise generated from the p-channel MOS transistor M1 and the n-channel MOS transistor M2 can be considerably reduced. Although the device areas of the mutual MOS transistors (M1 and M2) are equal to each other, the same electric characteristic can be obtained without variance. Furthermore, the parasitic capacity of the p-channel MOS transistor can match the parasitic capacity of the n-channel MOS transistor, and the difference between the rising characteristic and the falling characteristic of the drain current for the gate-source voltage can be greatly moderated.

Thus, in the above-mentioned circuit, not only the 1/f noise, but also the influence of the signal distortion caused by the variance of the electric characteristic s of the transistor device can be largely improved, thereby successfully configuring the low noise amplifier much lower in noise and higher in gain than the conventional devices.

Therefore, a new circuit for reducing the 1/f noise and the signal distortion generated by a low noise amplifier is not required, and the low noise amplifier can be downsized.

Additionally, since the 1/f noise can be reduced in the low frequency noise amplifier fist having a gain in the direct conversion receiving system by applying the configuration of the low noise amplifier according to an embodiment of the present invention to the direct conversion receiving system, the S/N ratio of the signal demodulated in the later stage can be improved, and the quality of the signal demodulated by the direct conversion receiving system can be enhanced. In addition, by applying the low noise amplifier according to an embodiment of the present invention, it is not necessary to newly provide a circuit for reducing the 1/f noise and the signal distortion, and a direct conversion receiver can be successfully downsized.

Also by applying the three-dimensionally structured CMOS transistor, a downsized, low power consumption, high performance, and low noise amplifier or a direct conversion receiver can be realized.

The present invention is not limited to the above-mentioned embodiments, but can also be configured as follows.

The frequency conversion circuit is not limited to a gilbert cell type circuit, but can be realized as any circuit that can mix a received signal with a local oscillation signal for conversion to a baseband signal.

The crystal surface of silicon is not limited to a combination of the surfaces (100) and (110), but can be a combination with another crystal surface such as the surfaces (100) and (111).

According to the present invention, the phase error, the amplification error, etc. between the I signal and the Q signal of the frequency conversion circuit can be reduced. Furthermore, the 1/f noise and the DC offset of the direct conversion receiving circuit can also be reduced. In addition, the influence of the channel length modulation effect can be decreased, and the signal distortion in the frequency conversion circuit and the direct conversion receiving circuit can be reduced. Since the DC offset of the frequency conversion circuit and 1/f noise can be reduced, the desired effect can be obtained specifically in the direct conversion receiving system.

**Claims**

1.  A frequency conversion circuit for direct conversion receiving which performs orthogonal transform on a received signal and converting the signal to an I signal and a Q signal, and is formed on the substrate of a semiconductor integrated circuit, comprising: a differential amplification circuit including an MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion.

2.  The frequency conversion circuit for direct conversion receiving according to claim 1, wherein the projecting portion has the top surface comprising a silicon surface (100), the side surface comprising a silicon surface (110), and the source and drain are formed on the projecting portion enclosing the gate and in left and right areas of the projecting portion of the silicon substrate.

3.  The frequency conversion circuit for direct conversion receiving according to claim 1 or 2, wherein the frequency conversion circuit comprises a p-channel MIS field-effect transistor and n-channel MIS field-effect transistor, and a gate width of a top surface and a side surface of a projecting portion of the p-channel MIS field-effect transistor is set such that current drive capability of the p-channel MIS transistor can be substantially equal to current drive capability of the n-channel MIS transistor.

4.  The frequency conversion circuit for direct conversion receiving according to claim 1 or 2, wherein the frequency conversion circuit comprises: a first mixer circuit comprising: a differential amplification circuit comprising the plurality of MIS field-effect transistors for receiving a received signal at each gate; and a differential amplification circuit comprising the plurality of MIS field-effect transistors for receiving a first local oscillation signal at each gate, and mixing the first local oscillation signal with the received signal; a second mixer circuit comprising: a differential amplification circuit comprising the plurality of MIS field-effect transistors for receiving a received signal at each gate; and a differential amplification circuit comprising the plurality of MIS field-effect transistors for receiving a second local oscillation signal having a 90° phase difference to the first local oscillation signal at each gate, and mixing the received signal with the second local oscillation signal; a local oscillation circuit for generating the first local oscillation signal; and a phase shifter for outputting the second local oscillation signal having the 90° phase difference to the first local oscillation signal.

5. A semiconductor integrated circuit for direct conversion receiving which performs orthogonal transform on a received signal and converting the signal to an I signal and a Q signal, and is formed on the substrate of a semiconductor integrated circuit, comprising: a circuit including: a p-channel MIS field-effect transistor and an n-channel MIS field-effect transistor in which a projecting portion is formed by a silicon substrate having a first crystal surface as a primary surface and a second crystal surface as a side surface, terminated hydrogen on the silicon surface is removed in plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a frequency conversion circuit having a differential amplification circuit including the p-channel MIS field-effect transistor or the n-channel MIS field-effect transistor.

6. The semiconductor integrated circuit for direct conversion receiving according to claim 5, wherein gate widths of a top surface and a side surface of the projecting portion of the p-channel MIS field-effect transistor and the n-channel MIS field-effect transistor are set such that the current drive capability of the p-channel MIS field-effect transistor can be substantially equal to current drive capability of the n-channel MIS field-effect transistor.

7. The semiconductor integrated circuit for direct conversion receiving according to claim 5 or 6, wherein the frequency conversion circuit comprises a CMOS circuit having the p-channel MIS field-effect transistor and the n-channel MIS field-effect transistor.

8. A direct conversion receiver comprising on a substrate of a semiconductor integrated circuit: a frequency conversion circuit having a differential amplification circuit formed by an MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and a DC amplifier having a differential amplification circuit formed by the MIS field-effect transistor.

9. A direct conversion receiver comprising on a substrate of a semiconductor integrated circuit: a frequency conversion circuit having a differential amplification circuit formed by an MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; and low noise amplifier formed by the MIS field-effect transistor.

10. A direct conversion receiver comprising on a substrate of a semiconductor integrated circuit: a frequency conversion circuit having a differential amplification circuit formed by an MIS field-effect transistor in which a projecting portion is formed by a silicon substrate having a first crystal surface as a primary surface and a second crystal surface as a side surface, terminated hydrogen on the silicon surface is removed in a plasma atmosphere of an inert gas, then a gate insulating film is formed on at least a part of a top surface and the side surface of the projecting portion at a temperature at or lower than about 550°C in the plasma atmosphere, a gate is formed on the gate insulating film, and a drain and a source are formed on both sides enclosing the gate insulating film of the projecting portion; a DC amplifier having a differential amplification circuit formed by the MIS field-effect transistor; and a low noise amplifier comprising the MIS field-effect transistor.

F I G. 1

INTERFACE LEVEL DENSITY

F I G. 2

F I G. 3

F I G. 4

16

F I G. 5

F I G. 6

F I G. 7

F I G. 8

## INTERNATIONAL SEARCH REPORT

| | International application No. |
|---|---|
| | PCT/JP2004/008216 |

| A. CLASSIFICATION OF SUBJECT MATTER |
|---|
| Int.Cl⁷ H01L27/092, H03D7/14, H04B1/30, H01L29/78, H01L21/336 |

According to International Patent Classification (IPC) or to both national classification and IPC

| B. FIELDS SEARCHED |
|---|
| Minimum documentation searched (classification system followed by classification symbols) |
| Int.Cl⁷ H01L27/092, H03D7/14, H04B1/30, H01L29/78, H01L21/336 |

Documentation searched other than minimum documentation to the extent that such documents are included in the fields searched

| Jitsuyo Shinan Koho | 1922–1996 | Jitsuyo Shinan Toroku Koho | 1996–2004 |
|---|---|---|---|
| Kokai Jitsuyo Shinan Koho | 1971–2004 | Toroku Jitsuyo Shinan Koho | 1994–2004 |

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| Y<br>A | JP 2002-118255 A (Toshiba Corp.),<br>19 April, 2002 (19.04.02),<br>Full text; all drawings<br>& US 2002/011612 A1<br>Full text; all drawings | 1,2,4,5,7-10<br>3,6 |
| Y<br>A | JP 2002-261097 A (Tadahiro OMI),<br>13 September, 2002 (13.09.02),<br>Full text; all drawings<br>& EP 1347506 A1<br>Full text; all drawings<br>& WO 2002/054473 A1    & JP 2002-261091 A<br>& KR 3068570 A | 1,2,4,5,7-10<br>3,6 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 August, 2004 (06.08.04) | 24 August, 2004 (24.08.04) |

| Name and mailing address of the ISA/ | Authorized officer |
|---|---|
| Japanese Patent Office | |
| Facsimile No. | Telephone No. |

Form PCT/ISA/210 (second sheet) (January 2004)

# EP 1 633 001 A1

## INTERNATIONAL SEARCH REPORT

International application No.

PCT/JP2004/008216

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2000-228611 A (Fujitsu Ltd.),<br>15 August, 2000 (15.08.00),<br>Par. No. [0004]; Fig. 2<br>(Family: none) | 1,2,4,5,7-10<br>3,6 |
| Y | JP 2000-106577 A (Toshiba Corp.),<br>11 April, 2000 (11.04.00),<br>Par. Nos. [0024] to [0026]; Fig. 1<br>(Family: none) | 4,8,10 |
| Y | JP 4-154312 A (Fujitsu Ltd., Fujitsu VLSI Ltd.),<br>27 May, 1992 (27.05.92),<br>Full text; all drawings<br>(Family: none) | 8,10 |

Form PCT/ISA/210 (continuation of second sheet) (January 2004)

22